(19) **Europäisches Patentamt / European Patent Office / Office européen des brevets**

(11) **EP 4 641 223 A1**

(12) **EUROPEAN PATENT APPLICATION**
published in accordance with Art. 153(4) EPC

(43) Date of publication:
**29.10.2025 Bulletin 2025/44**

(21) Application number: **23906156.7**

(22) Date of filing: **04.12.2023**

(51) International Patent Classification (IPC):
**G01R 31/08** (2020.01)    **G01R 31/52** (2020.01)
**G01R 31/00** (2006.01)

(52) Cooperative Patent Classification (CPC):
**G01R 31/00; G01R 31/08; G01R 31/52**

(86) International application number:
**PCT/ES2023/070724**

(87) International publication number:
**WO 2024/133992 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **19.12.2022 ES 202231078**

(71) Applicant: **CAF Power & Automation, S.L.U.**
**20009 San Sebastian (Gipuzkoa) (ES)**

(72) Inventors:
• **GARCIA PUERTOS, Victor**
**20009 San Sebastian (Gipuzkoa) (ES)**

• **GARCIA ARGUELLES, Gabriel**
**20009 San Sebastian (Gipuzkoa) (ES)**
• **AIARZAGUENA ALTUNA, Mikel**
**20009 San Sebastian (Gipuzkoa) (ES)**
• **MONTES PITA, Ignacio**
**20009 San Sebastian (Gipuzkoa) (ES)**
• **NIEVA FATELA, Txomin**
**20009 San Sebastian (Gipuzkoa) (ES)**

(74) Representative: **Evens, Paul Jonathan et al**
**Maguire Boss**
**24 East Street**
**St. Ives, Cambridgeshire PE27 5PD (GB)**

(54) **SYSTEM FOR DETECTING LEAKAGE CURRENTS FOR DRIVE SYSTEMS OF VEHICLES WITH AN ELECTRIC DRIVE SYSTEM**

(57)    The invention relates to a system for detecting leakage currents for drive systems of vehicles with an electric drive system with two or more traction converters (2, 2'), and with an auxiliary converter (4) fed by both drive chains (2, 2'), with the detection system comprising an inlet current sensor (5, 5') in the inlet line (1.1, 1,1') of each drive chain (1, 1'), and an outlet current sensor (6, 6') in each drive chain (1, 1') such that a supply line (4.1, 4.1') and a return line (4.2, 4.2') of the auxiliary converter, and a return line (1.2, 1.2') of the corresponding drive chain (1, 1') pass via said sensor (6, 6'), and with the detection system comprising control means which receive the information from the sensors (5, 5', 6 and 6') and identify which of the drive chains (1, 1') is producing a leakage current ($I_{fuga}$).

FIG. 1

## Description

### Technical field

The present invention relates to drive systems of vehicles with an electric drive system, relating more specifically to a system for detecting leakage currents in drive systems comprising an auxiliary converter with shared supply bus from two or more drive chains.

### State of the art

Vehicles powered by electric current have a drive system that transforms electrical energy into mechanical energy, which provides the necessary force to move said vehicle.

The drive system essentially consists of elements such as a preload, an electrical inlet filter, a traction converter and one or more motors, these being the elements that form the drive chain. Likewise, in order to prevent the degradation of any component from causing a voltage point connecting to the ground of the system and ultimately cause further damage such as a short circuit, these drive systems comprise a detection system for detecting bypass currents or ground leakage currents. These detection systems comprise a sensor arranged in the inlet line to the drive train and another sensor in the return line to the power supply source, such that the inlet current and the return current to the power supply source are measured. Control means are used to check whether the subtraction of these values is zero, if not, it is concluded that there is some current flow to earth, such that it returns to the return interconnection point of the train via the chassis thereof. To avoid this problem once the leak has been detected, the control means disconnect the drive chain.

In addition to the above elements, these vehicles also have an auxiliary electrical energy converter, hereinafter referred to as auxiliary converter, which is responsible for supplying electrical systems such as air conditioning, lighting, brakes, etc.

To feed the auxiliary converter, the conventional configuration adopted is to connect it directly to the power supply source, such as the catenary, or to connect it to the drive chain itself. The latter option has the advantage of reducing the number of components in the installation. In any case, this type of auxiliary converter has its own differential protection that disconnects it in the event of degradation of any of its components, without affecting the drive chains.

In the above-mentioned option where the auxiliary converter is connected to the drive train, in certain cases to increase the availability of the whole system, the auxiliary converter is connected to two independent drive trains, such that when one drive train fails, the other can still supply the auxiliary converter with all the power it needs, which requires the inclusion of two additional diodes in parallel at the inlet of the auxiliary converter, to protect the drive trains against unwanted reverse currents.

In this type of installation, the problem is that the system for detecting leakage currents implemented in the conventional way is unable to know how the current flows between positive and return in the auxiliary converter, such that including current detection sensors at the inlet and outlet of each drive chain forces part of the drive chain to be unprotected or the entire drive system to be disconnected for safety, stopping the vehicle.

### Object of the invention

In order to solve the problems presented above, the present invention proposes a system for detecting leakage currents for drive systems of vehicles with an electric drive system with an auxiliary converter, said drive systems having two or more traction converters, each to feed its corresponding motor, and the auxiliary converter fed by each of the drive chains, said detection system comprising an inlet current sensor in the supply inlet line of each drive chain, and an outlet current sensor arranged in each of the drive trains such that a supply line and a return line of the auxiliary converter, and a return line of the corresponding drive train, pass via said outlet current sensor to detect current, and with the detection system further comprising control means which receive the information from the inlet and outlet sensor of each drive train and identify which of the drive trains is producing a leakage current, send a signal to disconnect the traction converter of the drive train that is producing the leakage current.

In this way, the outlet current sensor of each drive chain detects the current that circulates through each of the lines that pass therethrough, each of the outlet current sensors transmitting said information to the control means that process it and detect whether leakage is produced, identifying which of the drive chains it has been produced. Once the drive train that has produced the current bypass has been identified, the control means send a signal to disconnect the identified drive train. This configuration results in the differential protection being carried out independently from each drive chain, such that the detection system is able to detect a current leakage, identifying whether it is produced in one traction converter or another, and also protect itself against same without affecting the rest of the converters of the system. In this way, the drive system is not left unprotected as would be the case in a conventional implementation, since the control means receive the information of the current passing through each of the lines of each drive chain and identify which of the drive chains is producing the leakage. In order for this to be possible, in addition, the auxiliary converter must have its own differential protection as is common in this type of system, since the control means will be responsible for sending a deactivation signal of the corresponding traction converter but not of the auxiliary converter.

Furthermore, faced with the problem presented in drive systems with at least two drive chains to which an auxiliary converter is connected, a person skilled in the art would consider including a sensor in each line, increasing the number of sensors, or making successive connections of both drive chains independently to detect where the current bypass is produced as an obvious solution to achieve the same effect, which increases the complexity of the start-up sequence and the cost of the installation. In contrast, the present invention solves the problem by simplifying and reducing the cost of installation and covering all possible cases in which current leakage may be produced.

In conclusion, this implementation according to the invention simply and economically detects any current leakage in any of the independent drive chains that form the drive system of the vehicle, and act by independently disconnecting the affected chain without affecting the proper operation of the drive system and without leaving it unprotected.

## Description of the figures

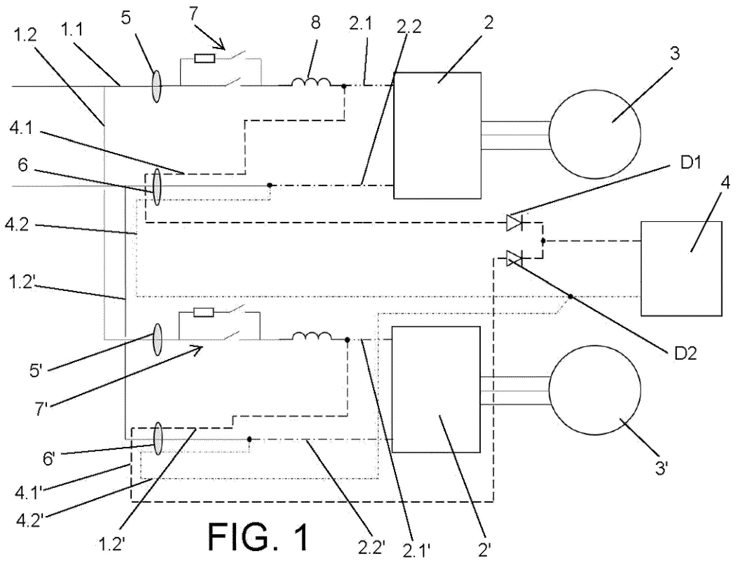

Figure 1 is a schematic view of a practical embodiment of the detection system, which is the subject matter of the invention.

Figure 2 is a schematic view as in figure 1, where the directions of the currents are indicated with thin arrows and the positive measurement direction of the sensors are indicated with thick arrows for clarity. Likewise, each drive chain is surrounded by respective ellipses with dashed lines and without referencing the rest of the elements of the system for better identification.

Figure 3 is an electrical diagram of a conventional drive system with a single drive chain connected to a catenary.

## Detailed description of the invention

The invention disclosed herein relates to a system for detecting leakage currents for drive systems of vehicles with an electric drive system with an auxiliary converter, the practical example shown in the figures being a railway vehicle. Said drive systems with two or more traction converters (2, 2'), each to feed its corresponding motor (3, 3'), and the auxiliary converter (4) fed by each of the drive chains (2, 2'), said detection system comprising an inlet current sensor (5, 5') in the supply inlet line (1.1, 1.1') of each drive train (1, 1'), and an outlet current sensor (6, 6') arranged in each of the drive trains (1, 1') such that a supply line (4.1, 4.1') and a return line (4.2, 4.2') of the auxiliary converter, and a return line (1.2, 1.2') of the corresponding drive train (1, 1'), pass via the same, and with the detection system further comprising control means which receive the information from the inlet (5, 5') and outlet (6, 6') sensor of each drive train (1, 1') and identify which of the drive chains (1, 1') is producing a leakage current ($I_{fuga}$), sending a signal to disconnect the traction converter (2, 2') of the drive chain (1, 1') that produces said leakage.

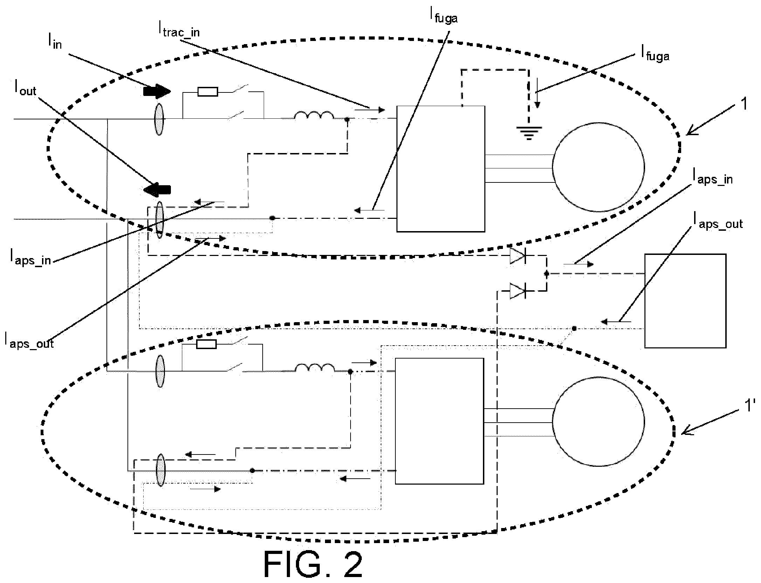

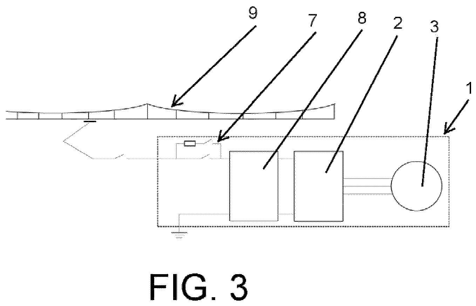

As can be seen in Figure 3 relating to a conventional drive system with a single drive chain (1), the drive chain (1) comprises a preloading step (7), an inlet filter (8) which is responsible for attenuating the generation of current harmonics, a traction converter (2) and a drive motor (3) for the railway train. Figures 2 and 3 show a practical exemplary embodiment of the invention, wherein the drive system comprises two drive chains (1, 1') with their corresponding traction converter (2, 2') to which the auxiliary converter (4) is connected.

For the practical example of the invention shown in figures 2 and 3, the power supply source is a direct current catenary (9), not ruling out the possibility that the power supply could come from a third rail, batteries, etc.

Thus, as can be seen in figure 2, the supply line (4.1, 4.1') of the auxiliary converter (4) is connected in the inlet filter (8, 8'), that is, in the inlet line (2.1, 2.1') of each traction converter (2, 2') to feed the same. In this configuration, two decoupling diodes (D1, D2) are incorporated to prevent damage to the drive chains (1, 1') due to unwanted currents.

According to the invention, a corresponding inlet sensor (5, 5') is connected to the inlet supply line (1.1, 1.1') of each drive train (1, 1'), which measures the current intensity supplying each drive train (1, 1'). Likewise, in the return of each drive train (1, 1') there is a corresponding outlet sensor (6, 6') arranged such that the supply (4.1, 4.1') and the return line (4.2, 4.2') of the auxiliary converter (4) and the return line (1.2, 1.2') of the corresponding drive train (1, 1'), circulate therethrough such that said outlet sensor (6, 6') of the corresponding drive train (1, 1') measures the current intensity through each of the aforementioned lines.

This information from the sensors (5, 5', 6, and 6') of each drive train (1, 1') is collected and processed together by the control means of the detection system to determine whether there is leakage at any point of the installation.

Thus, the control means process said information and identify which of the two drive chains (1, 1') is producing the current bypass in order to disconnect the traction converter (2, 2')which is producing the current leakage. To perform said identification, the control means carry out a calculation as shown in the following example in which is based on the existence of a ground leakage ($I_{fuga}$) in the first drive train (1).

To detect whether there is a leakage current, in the same way as in the conventional way, the calculation subtracts the inlet and outlet current values of each drive chain (1, 1') and if the difference is not zero, the control means will detect that there is leakage, and will identify which of the drive chains (1, 1') is producing said leakage, to disconnect the corresponding traction converter (2, 2') and send a signal to disconnect it.

Based on this premise, a practical calculation example is provided below, taking into account the currents circulating through the first drive chain (1), the equations involved in the calculation being the following:

$$I_{in} = I_{trac\_in} + I_{aps\_in} \qquad [1]$$

and

$$I_{out} = I_{aps\_in} + \left(I_{trac\_out} + I_{aps\_out}\right) - I_{aps\_out} \; [2]$$

Where:

- $I_{trac\_in}$ is the inlet current to the traction converter (2),
- $I_{trac\_out}$ is the return current of the traction converter (2),
- $I_{fuga}$ is the leakage current produced in the traction converter (2),
- $I_{aps\_in}$ is the inlet current to the auxiliary converter (4),
- $I_{aps\_out}$ is the return current of the auxiliary converter (4).

Taking these equations into account, the system for detecting current leakages compares the inlet current $I_{in}$ with the outlet current $I_{out}$ for each drive chain (1, 1'), such that a zero difference indicates that there is no leakage current, that is:

$$I_{fuga} = I_{in} - I_{out} \qquad [3]$$

Where $I_{fuga}$, is the leakage current produced in the traction converter (2, 2').

For the example shown in figure 2, which shows the direction of the electric currents by means of arrows, and taking into account for the following calculation example only the currents circulating through the first drive chain (1), it is held that:

$$I_{in} = I_{trac\_in} + I_{aps\_in} = \left(I_{trac\_out} + I_{fuga}\right) + I_{aps\_in} \qquad [4]$$

If the entire supply current ($I_{aps\_in}$) of the auxiliary drive (4) circulates in both the forward and return directions from the connections of the first drive converter (2), the outlet sensor (6) measures:

$$I_{out} = I_{aps\_in} + \left(I_{trac\_out} + I_{aps\_out}\right) - I_{aps\_out} \; [2]$$

And applying the equation [3] it is found that:

$$I_{fuga\_medida} = I_{in - Iout} = \left(I_{trac\_out} + I_{fuga}\right) + I_{aps\_in} - \left[I_{aps\_in} + \left(I_{trac\_out} + I_{aps\_out}\right) - I_{aps\_out}\right] = I_{fuga}$$

Therefore, is it shown that, with the proposed implementation, it is possible to obtain a measurement of the leakage current ($I_{fuga}$) produced in the first drive chain (1) and more specifically in the first traction converter (2).

Likewise, the control means perform the same calculation for the second drive chain (1'), such that said control means take into account the results obtained from both drive chains (1, 1') to be able to detect and identify any leakage produced in any of the traction converters (2, 2'), and send a signal to disconnect the drive chain (1, 1') that has produced the current leakage, such that the control means command contactors to isolate the corresponding part of the drive chain (1, 1').

According to another specific case for the practical example, if there were any unbalance in the connections that caused the return current circulation ($I_{aps\_out}$) of the return line (4.2, 4.2') of the auxiliary converter (4) to be distributed between the two drive chains (1, 1'), such that half of the current returned through each of the returns, the calculation would be as follows:

$$I_{in} = I_{trac\_in} + I_{aps\_in} = (I_{trac\_out} + I_{fuga}) + I_{aps\_in} \qquad [5]$$

$$I_{out} = I_{aps\_in} + (I_{trac\_out} + \frac{I_{aps\_out}}{2}) - \frac{I_{aps\_out}}{2} \qquad [6]$$

$$I_{fuga\_medida} = I_{in} - I_{out} = (I_{trac\_out} + I_{fuga}) + I_{aps\_in} - [I_{aps\_in} + (I_{trac\_out} + \frac{I_{aps\_out}}{2}) - \frac{I_{aps\_out}}{2}] = I_{fuga} \qquad [7]$$

Likewise, as for the first case, this same calculation would be performed for both drive chains (1, 1'), the control means detecting the leakage in any of the drive chains of the system. In this way it is shown that it would be equally feasible to detect the effect of ground leakage when this unbalance occurs and therefore to implement the detection system of the invention, even more so when this type of unbalance is not always equally distributed by both drive chains (1, 1') since due to construction, for example, due to variations in cable length, or even due to temperatures it is not possible to ensure said equal distribution of the current return from the auxiliary converter (4).

In this way, the detection system of the present invention provides greater safety to the drive system of the railway train of the practical embodiment of the invention shown in the drawings, avoiding damage to its components, or to people who may be harmed in the event of a current bypass, and all this by individualising the protection for each converter (2, 2', 4), disconnecting the converter in which the leak is produced without affecting the rest of the converters.

**Claims**

1.    A system for detecting leakage currents for drive systems of vehicles with an electric drive system with an auxiliary converter, said drive system with two or more traction converters (2, 2'), each to feed at least one corresponding motor (3, 3'), and the auxiliary converter (4) fed by each of the drive chains (2, 2'), said detection system comprising an inlet current sensor (5, 5') in the supply inlet line (1.1, 1.1') of each drive train (1, 1'), and an outlet current sensor (6, 6') arranged in each of the drive trains (1, 1') such that a supply line (4.1, 4.1') and a return line (4.2, 4.2') of the auxiliary converter (4), and a return line (1.2, 1.2') of the corresponding drive train (1, 1'), pass via said outlet current sensor (6, 6') to detect currents, and with the detection system comprising control means which receive the information from the inlet (5, 5') and outlet (6, 6') sensor of each drive train (1, 1') and identify which of the drive chains (1, 1') is producing a leakage current ($I_{fuga}$), sending a signal to disconnect the traction converter (2, 2') of the drive chain (1, 1') that produces said leakage ($I_{fuga}$).

FIG. 1

FIG. 2

FIG. 3

# INTERNATIONAL SEARCH REPORT

| International application No. |
| --- |
| PCT/ES2023/070724 |

## A. CLASSIFICATION OF SUBJECT MATTER

See extra sheet

According to International Patent Classification (IPC) or to both national classification and IPC

## B. FIELDS SEARCHED

Minimum documentation searched (classification system followed by classification symbols)
G01R

Documentation searched other than minimum documentation to the extent that such documents are included in the fields searched

Electronic data base consulted during the international search (name of data base and, where practicable, search terms used)

EPODOC, INVENES, WPI, NPL, INTERNET

## C. DOCUMENTS CONSIDERED TO BE RELEVANT

| Category* | Citation of document, with indication, where appropriate, of the relevant passages | Relevant to claim No. |
| --- | --- | --- |
| A | WO 2017082730 A1 (CONDUCTIS B. V.) 18/05/2017, page 3, lines 14-26; page 5, lines 20-25; page 9, lines 18-35; page 15, lines 3-17. | 1 |
| A | KR 20110115707 A (KRRI) 24/10/2011. | - |
| A | CN 112327209 A (CRRC QINGDAO SIFANG CO. LTD) 05/02/2021. | - |
| A | ANDREA MARISCOTTI: "Measuring the power quality of railway networks". Instrumentation And Measurement Technology Conference (i2mtc), 2010 IEEE, 20100503 IEEE, Piscataway, NJ, USA, 03/05/2010, pages 686 - 690 [on line] [retrieved on 04/10/2023]. ISSN ISBN 978-1-4244-2832-8; ISBN 1-4244-2832-7. | - |

☐ Further documents are listed in the continuation of Box C.      ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance. | |
| "E" earlier document but published on or after the international filing date | |
| "L" document which may throw doubts on priority claim(s) or which is cited to establish the publication date of another citation or other special reason (as specified) | "X" document of particular relevance; the claimed invention cannot be considered novel or cannot be considered to involve an inventive step when the document is taken alone |
| "O" document referring to an oral disclosure use, exhibition, or other means. | "Y" document of particular relevance; the claimed invention cannot be considered to involve an inventive step when the document is combined with one or more other documents , such combination being obvious to a person skilled in the art |
| "P" document published prior to the international filing date but later than the priority date claimed | "&" document member of the same patent family |

| Date of the actual completion of the international search | Date of mailing of the international search report |
| --- | --- |
| 12/03/2024 | **(15/03/2024)** |

| Name and mailing address of the ISA/ | Authorized officer |
| --- | --- |
| OFICINA ESPAÑOLA DE PATENTES Y MARCAS Paseo de la Castellana, 75 - 28071 Madrid (España) Facsimile No.: 91 349 53 04 | J. Frías López |
| | Telephone No. 913495455 |

Form PCT/ISA/210 (second sheet) (July 2022)

## INTERNATIONAL SEARCH REPORT

Information on patent family members

International application No.

PCT/ES2023/070724

| Patent document cited in the search report | Publication date | Patent family member(s) | Publication date |
|---|---|---|---|
| WO2017082730 A1 | 18.05.2017 | EP3374244 A1<br>NL2015770B B1 | 19.09.2018<br>29.05.2017 |
| KR20110115707 A | 24.10.2011 | KR101090957B B1 | 08.12.2011 |
| CN112327209 A | 05.02.2021 | CN112327209B B | 13.09.2022 |

Form PCT/ISA/210 (patent family annex) (July 2022)

## INTERNATIONAL SEARCH REPORT

| International application No. |
| --- |
| PCT/ES2023/070724 |

CLASSIFICATION OF SUBJECT MATTER

***G01R31/08*** (2020.01)
***G01R31/52*** (2020.01)
*G01R31/00* (2006.01)